Europäisches Patentamt

European Patent Office

Office européen des brevets

(11) Numéro de publication: **0 069 072**
A2

## (12) DEMANDE DE BREVET EUROPEEN

(21) Numéro de dépôt: **82810264.0**

(22) Date de dépôt: **14.06.82**

(51) Int. Cl.³: **H 03 F 1/56**, H 03 F 3/50

(30) Priorité: **29.06.81 CH 4260/81**

(43) Date de publication de la demande: **05.01.83**
**Bulletin 83/1**

(84) Etats contractants désignés: **DE GB NL**

(71) Demandeur: **ASULAB S.A., Faubourg du Lac 6,
CH-2502 Bienne (CH)**

(72) Inventeur: **Rusznyak, Andreas, Avenue des Cavaliers 3,
CH-1224 Chene-Bougeries (CH)**

(74) Mandataire: **Gresset, Jean, ASUAG Département
Brevets et Licences Faubourg du Lac 6, CH-2501 Bienne
(CH)**

(54) **Circuit amplificateur.**

(57) L'invention concerne un circuit électronique amplificateur pour sonde à haute impédance servant à la mesure de tension électriques.

Le circuit amplificateur comprend un transistor d'entrée à effet de champ (15) monté en source suiveuse, un transistor bipolaire (17) monté en émetteur-suiveur et commandé par le transistor (15), une source de courant (18) servant de charge au transistor (17), un amplificateur (19) de gain positif G légèrement inférieur à l'unité dont l'entrée est commandée par le transistor (15), enfin une résistance (20), servant de charge au transistor (15), qui relie la source de ce transistor à la sortie (8) de l'amplificateur (19), cette sortie servant également de sortie au circuit amplificateur, lequel est alimenté par une source de tension appliquée entre la source de courant (18) et le collecteur du transistor (17). Grâce à l'amplificateur (19), la résistance de charge effective vue par le transistor (15) vaut $R_{20}/(1-G)$, $R_{20}$ étant la valeur de la résistance (20). Si G est légèrement inférieur à l'unité, une résistance de charge effective importante pourra être obtenue avec une petite valeur de $R_{20}$. Il en résultera une chute de tension faible aux bornes de la résistance 20, permettant d'alimenter le circuit amplificateur avec une tension basse et de réduire sa consommation en énergie.

L'invention s'applique notamment aux mesures de tensions biologiques ou pour les tests des circuits intégrés.

ESA 75 BE

IS/cb

## CIRCUIT AMPLIFICATEUR

La présente invention se rapporte aux instruments comportant une sonde pour la mesure des tensions électriques; elle concerne plus particulièrement un circuit électronique amplificateur pour une telle sonde conférant à celle-ci une impédance d'entrée élevée, de façon à réduire au minimum la perturbation produite par la sonde lors de la mesure de signaux continus ou variables de très faible énergie.

De telles mesures sont courantes, par exemple en biologie, en chimie, voire dans les tests des circuits intégrés.

La caractéristique essentielle d'une sonde pour ces mesures, que la sonde soit passive ou active, est donnée par son impédance d'entrée dont la valeur doit être aussi élevée que possible. Cette impédance peut être représentée avec une bonne approximation par une résistance mise en parallèle avec une capacité. Les meilleures performances sont obtenues par les sondes contenant des dispositifs actifs, tels que les transistors, car elles permettent d'obtenir des signaux de sortie sensiblement de même grandeur que les signaux mesurés. Le circuit pour sonde selon la présente invention entre dans cette catégorie.

Les dispositifs actifs actuellement disponibles, tels que par exemple les transistors à effet de champ ou MOS, permettent de réaliser des résistances d'entrée très élevées. Par contre, les capacités parasites associées à ces dispositifs ne sont pas toujours négligeables et leur influence, si aucune précaution n'est prise, peut devenir une cause d'erreur importante, en particulier dans la mesure de tensions en haut fréquence.

L'asservissement, consistant à imposer à une borne d'un élément (résistance ou capacité par exemple) une tension sensiblement égale à celle qui existe sur son autre borne, est le moyen généralement utilisé pour atténuer l'effet de cet élément sur un circuit. En effet, si cette tension est nulle, le courant qui traverse l'élément sera nul également, et le circuit se comportera comme si cet élément avait une impédance infinie.

Des circuits basées sur ce principe sont connus depuis longtemps et permettent d'obtenir de bonnes performances. Dans la littérature on trouve, par exemple, l'article de D.P. Stokesberry (Proc. of the IEEE, Jan 1966, p 66) qui décrit un circuit simple pour sonde, utilisant deux transistors discrets et un amplificateur Darlington.

Le fonctionnement correct de ce circuit nécessite que le gain en tension des émetteurs-suiveurs soit voisin de l'unité, ce qui exige un courant de polarisation important pour les transistors et des résistances de charge de valeur élevée. Il en résulte que l'alimentation de ce circuit demande une tension élevée, 75 volts dans ce cas, entraînant une forte dissipation thermique. Ceci constitue naturellement une limitation importante dans l'utilisation d'un tel circuit et le rend impropre en outre à une réalisation sous forme intégrée.

Un autre circuit, ne présentant pas ces défauts, a été décrit plus récemment par H.J. De Man et al. (IEEE J. Solid-State

3        00069072

Circuits, vol. SC-12, No 3, June 1977). Il est réalisé sous forme de circuit intégré et ne nécessite que 18 volts comme tension d'alimentation. Ses caractéristiques sont très bonnes, puisqu'il a une résistance d'entrée supérieure à 1000 MΩ et une capacité d'entrée de l'ordre de 0.1 pF. Cependant, ce circuit a une structure complexe, basée sur l'utilisation d'un amplificateur différentiel. Il comporte une dizaine de transistors, ainsi que de nombreux autres composants.

La présente invention a pour but principal de fournir un circuit électronique pour sonde de mesure à haute impédance utilisant l'asservissement et présentant l'avantage, par rapport aux circuits connus, de pouvoir fonctionner avec une tension d'alimentation faible, de dissiper peu de puissance, d'avoir une structure simple ne comportant aucune résistance de valeur élevée, de pouvoir être facilement réalisé soit à l'aide de composants discrets ne nécessitant aucun appairage ou sélection, soit sous forme de circuit intégré et, enfin, de présenter de très bonnes caractéristiques du point de vue de son impédance d'entrée jusqu'à des fréquences élevées, par exemple de plusieurs MHz.

Pour atteindre ce but, le circuit électronique amplificateur selon l'invention, présentant une entrée à haute impédance et une sortie à basse impédance et comportant :

- un transistor à effet de champ dont la grille constitue ladite entrée, un premier transistor bipolaire dont la base est reliée à la source du transistor à effet de champ et l'émetteur au drain du même transistor, une source de courant dont une borne est reliée à l'émetteur du premier transistor bipolaire, une source d'alimentation ayant deux pôles dont le premier est relié à l'autre borne de la source de courant, et une première résistance dont une borne est reliée à la source du transistor à effet de champ,

– est principalement remarquable en ce qu'il comprend, en outre, un amplificateur de gain positif légèrement inférieur à l'unité dont l'entrée est reliée soit à la source, soit au drain du transistor à effet de champ, la sortie à l'autre borne de la première résistance et les bornes d'alimentation aux deux pôles de la source d'alimentation, le collecteur du premier transistor bipolaire étant, de son côté, relié soit à la sortie dudit amplificateur, soit au second pôle de la source d'alimentation, la sortie dudit circuit étant constituée soit par l'émetteur du premier transistor bipolaire, soit par la sortie dudit amplificateur.

L'avantage résultant de l'utilisation d'un amplificateur de gain positif G, légèrement inférieur à l'unité, provient du fait que la première résistance, qui joue le rôle de résistance de charge du transistor a effet de champ et dont il est avantageux que la valeur soit aussi élevée que possible, peut être remplacée, grâce à l'amplificateur, par une résistance $(1-G)$ fois plus faible, sans diminuer le gain du transistor à effet de champ. Il en résulte que, pour un même courant dans le transistor MOS, la chute de tension dans la résistance sera $(1-G)$ fois plus faible dans le cas de la présente invention que dans celui correspondant à un circuit conventionnel. Cette diminution de tension se répercute naturellement de façon favorable sur la tension d'alimentation, qui peut être diminuée de la même quantité. D'autre part, comme l'amplificateur de gain G peut être réalisé à l'aide d'un seul transistor supplémentaire, le circuit selon l'invention reste très simple, facilement intégrable, tout en présentant une impédance d'entrée très élevée.

D'autres caractéristiques de la présente invention ressortiront de la description qui va suivre, faite en regard des dessins annexés et donnant, à titre explicatif mais nullement limitatif, une forme de réalisation d'un tel circuit pour sonde de mesure à haute impédance. Sur ces dessins :

- la figure 1 représente schématiquement une sonde associée à l'objet à mesurer et à l'instrument indiquant la valeur mesurée;

- la figure 2 représente un circuit connu simple à un seul transistor pour une sonde, ainsi que les capacités parasites;

- la figure 3 représente un circuit connu, plus évolué, pour sonde où les capacités parasites sont compensées;

- la figure 4a représente une exécution préférentielle d'un circuit pour sonde selon l'invention;

- les figures 4b, 4c et 4d sont des variantes de la figure 4a, obtenues en effectuant un branchement différent de l'entrée de l'amplificateur et du collecteur du premier transistor bipolaire;

- la figure 5 montre dans le détail le schéma d'un circuit selon l'invention;

- la figure 6 montre une version améliorée du circuit de la figure 5 selon l'invention; enfin

- la figure 7 montre le schéma d'un amplificateur d'interface pouvant être branché directement au circuit de la figure 6.

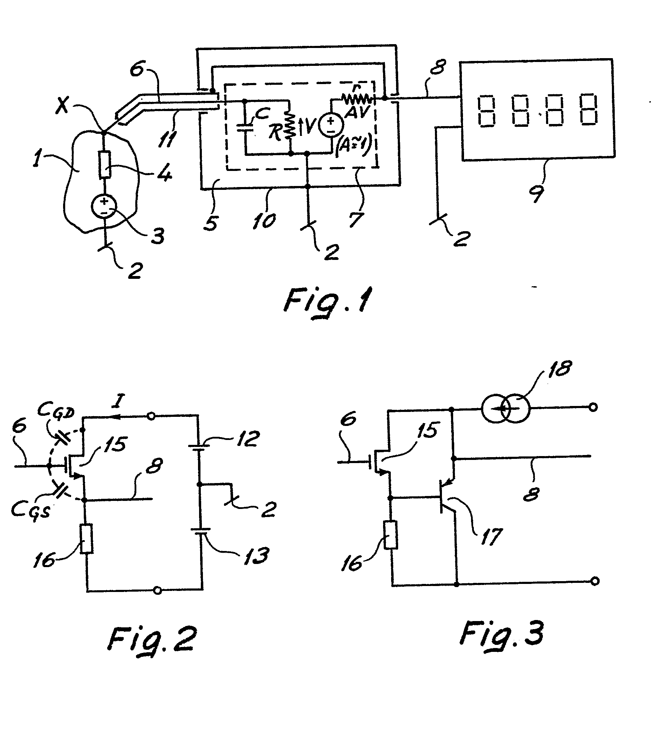

Pour situer le problème et rendre la déscription de l'invention plus claire, la figure 1 montre la façon dont est faite la mesure d'une tension électrique au point X d'un objet 1, par rapport à un point de masse 2. L'objet à mesurer 1 peut être aussi bien une cellule biologique qu'un circuit intégré. On peut le remplacer du point de vue électrique par un schéma équivalant comprenant une source de tension 3 mise en série avec une impédance 4, généralement résistive et de valeur élevée.

La mesure est faite à l'aide d'une sonde 5 dont l'électrode de mesure 6 est mise en contact avec le point X. L'électrode 6 est reliée à un circuit actif 7. Ce circuit peut être représenté par un schéma équivalent comprenant une capacité C et une résistance R, connectées entre l'électrode 6 et le point de masse 2, ainsi qu'un générateur de tension AV dont l'une des bornes est reliée à la masse 2 et l'autre borne à l'une des bornes d'une résistance r de faible valeur, représentant la résistance de sortie du circuit. L'autre borne de la résistance r constitue la sortie 8 du circuit de la sonde 5. Cette sortie est reliée à l'entrée d'un oscilloscope ou, comme cela est représenté sur la figure 1, à un voltmètre 9 qui affiche, par exemple sous forme numérique, la valeur de la tension mesurée. Enfin, un blindage 10, relié à la masse 2, protège la sonde contre les perturbations électriques.

La tension V existant au point X au moment de la mesure se retrouve également aux bornes de la capacité C et de la résistance R. Le circuit de la sonde est généralement conçu de façon que le générateur de tension AV fournisse une tension légèrement inférieure à V. Cela signifie que la valeur de A, laquelle définit le gain du circuit, doit être positive et légèrement inférieure à l'unité.

Pour que la mesure soit précise, il faut que l'impédance d'entrée de la sonde, constituée par la capacité C et la résistance R, soit grande par rapport à l'impédance 4, supposée déjà de valeur élevée, que présente l'objet à mesurer 1. Comme la capacité parasite existant entre l'électrode 6 et les objets avoisinants vient s'ajouter à la capacité C, son influence doit être réduite au minimum. A cet effet, l'électrode 6 est protégée par un blindage 11, lequel est relié à la sortie 8 du circuit de la sonde. Le blindage 11, dont la capacité par rapport aux objets avoisinants n'est pas génante, se trouve donc porté à la tension AV et la tension existant entre l'électrode 6 et le blindage 11 vaut ainsi (1-A) V. Le courant qui traverse la capacité inévitable existant entre l'électrode 6 et le blindage 11 est donc (1-A) fois plus faible dans ce cas que dans celui où le blindage serait relié directement au point de masse 2. Autrement dit la capacité apparente, qui charge l'électrode 6, due au blindage 11, est réduite par le facteur (1-A) à une valeur qui peut être négligeable par rapport à la capacité C de la sonde.

La figure 2 montre un circuit connu simple, pouvant être utilisé dans une sonde. Il comprend un transistor d'entrée à effet de champ 15, par exemple du type MOS à canal N, et une résistance 16 reliée à la source du transistor. La grille du transistor 15 est connectée à l'électrode de mesure 6 et la source de ce transistor constitue la sortie 8 du circuit de la sonde. Deux batteries 12 est 13 reliées en série, alimentent le circuit. Le point commun à ces batteries est relié au point de masse 2, le pôle positif de la batterie 12 est connecté au drain du transistor 15 et le pôle négatif de la batterie 13 à la résistance 16. Les tensions des batteries sont choisies de façon à déterminer le point de travail désiré du transistor 15, lorsque l'électrode de mesure 6 ne reçoit aucun signal.

Le transistor 15 est connecté en source-suiveuse dont le gain A', positif et et plus petit que 1 vaut

$$A' = \frac{g_m \ R_{16}}{1 + g_m \ R_{16}}$$

où $g_m$ est la transconductance du transistor 15 et $R_{16}$ la valeur de la résistance 16. Si l'on remarque que $g_m$ est proportionnel à la racine carrée du courant I qui traverse le transistor, on voit que le gain A' sera d'autant plus voisin de l'unité que I et $R_{16}$ sont grands. Ceci entraîne une tension d'alimentation du circuit élevé et une forte dissipation d'énergie dans les éléments.

Le circuit de la figure 2 permet donc de mesurer la tenison d'entrée avec une amplification A'. Entre la tension d'entrée et celle de sortie, un décalage constant peut toutefois exister, lequel ne dépend que des caractéristiques des éléments utilisés. En tenant compte de ce décalage, des tensions continues et alternatives peuvent être mesurées.

Sur la figure 2 sont également représentées les capacités parasites $C_{GS}$ entre la grille et la source, et $C_{GD}$ entre la grille et le drain du transistor 15. Ces capacités interviennent directement dans la capacité d'entrée C de la sonde, mais de façon différente. Comme la tension du drain du transistor 15 est constante, la capacité $C_{GD}$ se reporte entièrement sur l'électrode 6. Par contre, puisque la tension existant entre la grille et la source du transistor 15 est de (1-A') fois la tension de mesure, la valeur apparente de la capacité $C_{GS}$ qui charge effectivement l'électrode 6 ne vaut que (1-A') $C_{GS}$. La capacité d'entrée de la sonde est donc

$$C = C_{GD} + (1-A') \, C_{GS}$$

dans le cas de la figure 2.

Un circuit amélioré ayant une capacité d'entrée plus faible que dans le cas de la figure 2 est représenté sur la figure 3. Ce circuit comprend, comme dans le cas précédent, le transistor d'entrée MOS 15 à la source duquel est reliée la résistance 16 et, en outre, un transistor 17, par exemple du type bipolaire, dont la base est reliée à la source du transistor 15, l'émetteur au drain du même transistor et le collecteur à la borne libre de la résistance 16. Enfin, une source courant 18 a une de ses bornes connectée à l'emetteur du transistor 17. La grille de commande du transistor 15 est reliée à l'électrode de mesure 6 et l'émetteur du transistor 17 constitue la sortie 8 du circuit de la sonde. Les capacités parasites du transistor 15, pas plus que la source d'alimentation du circuit qui relie le collecteur du transistor 17 à l'autre borne de la source de courant 18, ne sont représentées ni sur la figure 3, ni sur les suivantes.

Le transistor 17 fonctionne en émetteur-suiveur, ayant la source de courant 18 comme charge. Soit A" le gain, positif et légèrement inférieur à 1, de cet émetteur-suiveur. Le gain global entre la grille du transistor 15 et l'émetteur du transistor 17 vaut alors A'A". La tension qui apparaît entre la grille et l'émetteur est (1-A'A") fois la tension de mesure et la valeur apparente de la capacité grille-drain du transistor 15 se réduit à (1-A'A") $C_{GD}$, pour les mêmes raisons que celles exposées à l'occasion de la capacité grille-source. La capacité d'entrée de la sonde du circuit de la figure 3 vaut ainsi

$$C = (1-A'A'') \ C_{GD} + (1-A') \ C_{GS},$$

valeur qui peut être rendue très faible, de l'ordre de 0.1 pF.

Le dessin de la figure 4a représente un circuit préférentiel pour sonde selon l'invention. Ce circuit se compose des transistors 15 et 17 ainsi que de la source de courant 18 qui sont connectés de la même manière que dans la figure 3 et, en plus, d'un amplificateur 19 de gain positif G légèrement inférieur à l'unité, enfin, d'une résistance 20 constituant la charge du transistor 15. L'amplificateur 19 est relié à la source d'alimentation, non représentée, par les connexions 21 et 22. A la source du transistor 15 est reliée une borne de la résistance 20 ainsi que l'entrée de l'amplificateur 19. A la sortie 8 de cet amplificateur est connectée l'autre borne de la résistance 20. Le collecteur du transistor 17 est relié, de son côté, à un pôle de la source d'alimentation. La sortie 8 de l'amplificateur 19 constitue la sortie préférentielle du circuit, mais l'émetteur du transistor 17 peut également servir à cette fin.

Du point de vue de la capacité d'entrée de la sonde, les circuits des figures 3 et 4a se comportent de façon similaire. Par contre, la résistance 20 de la figure 4a peut avoir une valeur beaucoup plus faible que la résistance correspondante 16 de la figure 3, tout en jouant le même rôle de résistance de charge élevée pour le transistor 15. En effet, grâce à l'amplificateur 19 de gain G et pour une tension de mesure donnée, la tension aux bornes de la résistance 20 est (1-G) fois plus faible que celle qui apparaît aux bornes de la résistance 16. En désignant par $R_{20}$ la valeur de la résistance 20, la valeur apparente qu'elle présente pour le

transistor 15 vaut $R_{20}/(1-G)$. En l'égalant à la valeur $R_{16}$ de la résistance 16 il vient

$$R_{16} = R_{20}/(1-G).$$

Si G est positif et légèrement inférieur à l'unité, $R_{16}$ apparaîtra comme ayant une valeur élevée, même si celle de $R_{20}$ est faible. Le même courant de polarisation du transistor 15, produira ainsi dans la résistance 20 du circuit de la figure 4a une chute de tension plus faible que dans la résistance 16 du circuit de la figure 3. Cette différence de tension permettra de diminuer d'autant la tension d'alimentation du circuit et sa puissance dissipée. C'est là le but principal recherché par la présente invention.

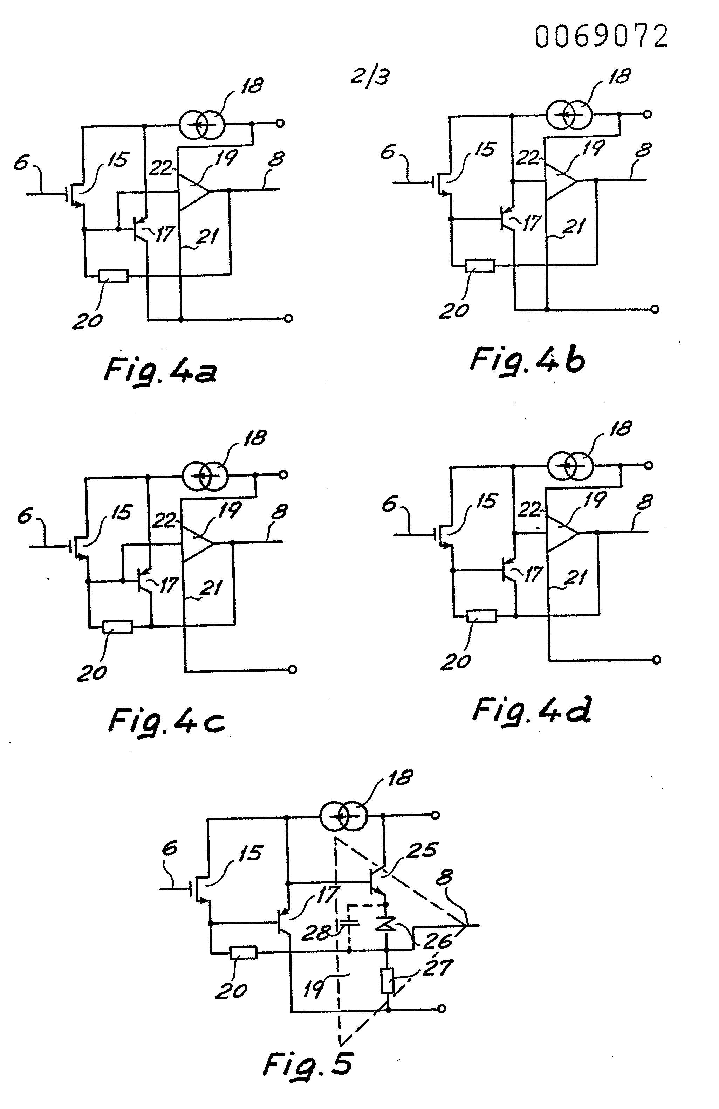

En variante de la figure 4a, l'entrée de l'amplificateur 19 peut être reliée à l'émetteur du transistor 17, ce qui est représenté sur la figure 4b. Tous les éléments qui se trouvent dans ces deux figures étant par ailleurs identiques, ils portent les mêmes références. Le transistor 17, en liaison avec la source de courant 18, ayant un gain A", le gain G précédemment utilisé pour déterminer la valeur $R_{20}$ de la résistance 20, doit être remplacé de façon évidente dans cette nouvelle configuration par $G' = A''G$. Les gains A" et G étant positifs et légèrement inférieurs à l'unité, il en sera de même pour $G'$.

Le collecteur du transistor 17 peut être relié, comme autre variante des figures 4a et 4b, à la sortie 8 de l'amplificateur 19, comme c'est représenté sur les figures 4c et 4d. Ceci présente l'avantage de diminuer l'effet de la capacité collecteur-base du transistor 17, sans modifier le principe de fonctionnement des circuits.

A titre d'exemple, la figure 5 représente un circuit correspondant à la variante représentée sur la figure 4b qui vient d'être
décrite. Les figures 4b et 5 ont en commun les transistors 15 et 17,
la source de courant 18 et la résistance 20 déjà décrits. Il y a lieu
de noter que la source de courant 18 peut être réalisée très simplement, de façon connue, à l'aide d'un transistor à effet de champ
ou bipolaire ou, plus approximativement, par une résistance. L'amplificateur 19 dans la figure 5 comprend un transistor 25, par
exemple du type bipolaire mais de polarité inverse à celle du transistor 17, monté en émetteur-suiveur, dont la base, qui correspond
à l'entrée de l'amplificateur 19, est reliée à l'émetteur du transistor
17 et son collecteur est connecté au point commun formé par la
source de courant 18 et un pôle de la source d'alimentation non
représentée; l'émetteur du transistor 25 est relié de son côté à une
borne d'une diode Zener 26, l'autre borne de cette diode constitue
la sortie de l'amplificateur 19 et la sortie préférentielle 8 du circuit
de la sonde; à cette sortie est reliée l'autre borne de la résistance
20 et une borne d'une résistance 27, l'autre borne de cette dernière
résistance étant connectée au collecteur du transistor 17 auquel est
également relié l'autre pôle de le source d'alimentation non représentée. Un condensateur 28 peut être branché en parallèle sur la
diode Zener 26 afin d'améliorer le comportement du circuit aux fréquences élevées. Le gain du transistor 25 associé à la résistance
27, représente le gain G de l'amplificateur 19. La sortie du circuit
de la sonde peut aussi être prise sur l'émetteur du transistor 25 ou
sur l'émetteur du transistor 17.

Le circuit de la figure 5 n'est pas critique du point de vue de
la valeur des éléments. Il peut être monté avec des composants discrets en nombre restreint ne nécessitant ni sélection ni appairage et son point de travail s'ajuste automatiquement. Dissipant peu d'énergie et n'ayant aucune résistance de valeur élevée, ce circuit se prête aussi bien à l'intégration. Ces différentes propriétés constituent un autre avantage de la présente invention.

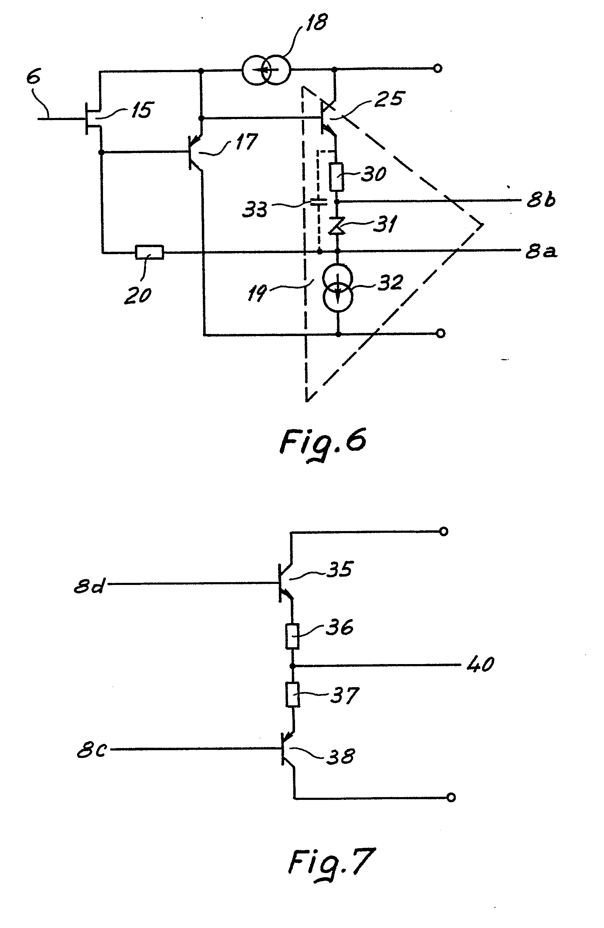

Le circuit amplificateur de la figure 6, correspondant à une autre forme d'exécution selon l'invention, est une version améliorée du circuit de la figure 5. Les éléments communs aux deux versions sont désignés par les mêmes numéros de référence. L'amélioration porte essentiellement sur les caractéristiques de l'amplificateur 19 dont la résistance 27 a été remplacée par une source de courant 32. Une des bornes de la source de courant 32 de la figure 6 est connectée à une des bornes de la source d'alimentation et l'autre borne à une des bornes d'une diode Zener 31, qui joue un rôle analogue à la diode Zener 26 de la figure 5. En outre, un résistance variable 30 relie l'émetteur du transistor 25 à l'autre borne de la diode Zener 31. Une capacité 33 peut enfin être connectée entre l'émetteur du transistor 25 et le point de jonction de la diode Zener 31 avec la source de courant 32. Le but de la capacité 33 est d'améliorer le comportement du circuit en haute fréquence, de la même manière que la capacité 28 dans le circuit de la figure 5.

L'amplificateur 19 de la figure 6 a deux sorties, une sortie principale 8a, prise sur le point de jonction entre la diode Zener 31 et la source de courant 32, et une sortie auxiliaire 8b, prise sur le point de jonction entre la résistance 30 et la diode Zener 31. Une des bornes de la résistance 20 est reliée à la sortie 8a, qui joue ainsi un rôle analogue à la sortie 8 du circuit de la figure 5. Si l'électrode d'entrée 6 reçoit un signal, des tensions alternatives de même amplitude et en phase apparaîtront sur les sorties 8a et 8b, mais leurs tensions continues seront décalées de la valeur de la tension de la diode Zener 31. L'écart de tension continue entre l'entrée 6 et l'une des sorties 8a ou 8b peut être modifié en variant la résistance 30 de façon, par exemple, a rendre nulle la tension continue entre l'entrée 6 et la sortie principale 8a lorsque le circuit est au point de repos. La diode Zener 31 étant parcourue par un courant constant, imposé par la source de courant 32, cette diode Zener peut tout aussi bien être remplacée par un dipôle passif comprenant soit une ou plusieurs diodes simples, soit une résistance.

Le transistor 25 de l'amplificateur 19, visible sur les figures 5 et 6, est monté en émetteur-suiveur. La charge de ce transistor est constituée par la résistance 27 de la figure 5 ou par la source de courant 32 de la figure 6. Or, il est bien connu que les performances d'un transistor monté en émetteur-suiveur sont d'autant meilleures que la charge a une valeur élevée. Une charge élevée a, en effet, l'avantage d'augmenter l'impédance d'entrée du transistor, de rapprocher son gain de l'unité et, enfin, de rendre son fonctionnement moins sensible aux variations de la tension d'alimentation. Comme une source de courant est théoriquement équivalente à une charge de valeur infinie, qu'elle ne nécessite pas de tension d'alimentation élevée et qu'elle peut être réalisée très simplement de façon connue à l'aide d'un seul transistor, son utilisation ne présente que des avantages.

L'avantage principal du circuit amplificateur de la figure 6 résulte de ce que le gain G, déjà défini pour l'amplificateur 19, est plus proche de l'unité dans ce circuit que dans celui de la figure 5.

Par ailleurs, comme cela a été montré, plus la différence (1-G) est petite, plus la résistance 20 pourra avoir une valeur faible à performances égales du circuit amplificateur. Or, une faible valeur de la résistance 20 permet d'alimenter le circuit amplificateur avec une tension basse, ce qui constitue un des buts visés par la présente invention.

Chacune des sorties 8a et 8b de l'amplificateur de la figure 6 peut servir à attaquer un instrument de mesure, par exemple un voltmètre électronique ou un oscilloscope. Pour ne pas dégrader les performances de l'amplificateur, surtout en haute fréquence, la charge capacitive que représente l'instrument de mesure ne doit cependant pas dépasser environ 10 pF. C'est une valeur faible qui peut nécessiter l'emploi d'une sonde, même peu performante, entre l'amplificateur et l'instrument de mesure. Or une sonde, si elle est formée d'éléments passifs, provoque une atténuation du signal, ce qui diminue d'autant la sensibilité de l'instrument auquel elle est reliée.

Pour éviter cet inconvénent, qui se présente avec tous les circuits amplificateurs décrits, il est avantageux d'utiliser à la place de la sonde un circuit amplificateur d'interface. Un circuit amplificateur d'interface qui s'adapte particulièrement bien au circuit amplificateur de la figure 6, est représenté sur la figure 7. Il se compose d'un transistor bipolaire 35, de polarité inverse à celle du transistor 17, dont le collecteur est relié à une borne de la source d'alimentation et l'émetteur à une borne d'une résistance 36. L'autre borne de cette résistance est reliée à une borne d'une résistance 37 dont l'autre borne est reliée à l'émetteur d'un transistor bipolaire 38, de même polarité que celle du transistor 17. Le collecteur du transistor 38 est relié à l'autre borne de la source d'alimentation. Les résistances 36 et 37 servent à définir le courant passant à travers les transistors 35 et 38. Cet amplificateur d'interface a deux entrées 8c et 8d constituées repsectivement par les bases des transistors 38 et 35, et une sortie 40 prise sur le point de jonction des résistances 36 et 37.

Les entrées 8c et 8d de l'amplificateur d'interface de la figure 7 peuvent être directement reliées respectivement aux sorties 8a et 8b de l'amplificateur de la figure 6, pour autant que la diode Zener 31 et les résistances 36 et 37 aient été convenablement choisies. Cette association permet de former un amplificateur unique, de gain très voisin de l'unité, dont l'entrée est référenciée 6 et la sortie référencié 40. L'écart de tension continue entre cette entrée et cette sortie peut être annulée à l'aide de la résistance variable 30. Si la valeur des résistances 36 et 37 est suffisamment faible, la sortie 40 peut supporter une charge capacitive d'environ 100 pF et être utilisée pour attaquer directement un instrument de mesure.

REVENDICATIONS

1. Circuit électronique amplificateur ayant une entrée (6) à haute impédance et une sortie (8) à basse impédance, comprenant :

- un transistor à effet de champ (15) dont la grille constitue ladite entrée;

- un premier transistor bipolaire (17) dont la base est reliée à la source du transistor à effet de champ (15) et l'émetteur au drain du même transistor;

- une première source de courant (18) dont une borne est reliée à l'émetteur du premier transistor bipolaire (17);

- une source d'alimentation ayant deux pôles dont le premier est relié à l'autre borne de la première source de courant (18); et

- une première résistance (20) dont une borne est reliée à la source du transistor à effet de champ (15),

caractérisé en ce qu'il comporte, en outre, un amplificateur (19) de gain positif légèrement inférieur à l'unité dont l'entrée est reliée soit à la source, soit au drain du transistor à effet de champ (15), la sortie à l'autre borne de la première résistance (20) et les bornes d'alimentation aux deux pôles de la source d'alimentation, le collecteur du premier transistor bipolaire (17) étant, de son côté, relié soit à la sortie (8) dudit amplificateur (19), soit au second pôle de la source d'alimentation, la sortie dudit circuit étant constituée soit par l'émetteur du premier transistor bipolaire (17), soit par la sortie (8) dudit amplificateur (19).

2. Circuit électronique selon la revendication 1, caractérisé en ce que ledit amplificateur (19) comprend :

- un second transistor bipolaire (25), de polarité inverse à celle du premier transistor bipolaire (17), dont la base est reliée à l'émetteur du premier transistor bipolaire (17) et le collecteur au point formé par la liaison de la première source de courant (18) au premier pôle de la source d'alimentation;

- une diode Zener (26) dont une borne est reliée à l'émetteur du second transistor bipolaire (25); et

- une seconde résistance (27) dont une borne est reliée au point formé par la liaison de l'autre borne de la première résistance (20) à l'autre borne de la diode Zener (26) et l'autre borne au second pôle de la source d'alimentation;

- la sortie dudit circuit étant constituée soit par l'émetteur du premier transistor bipolaire (17), soit par l'une des deux bornes de la diode Zener (26).

3. Circuit électronique selon la revendication 2, caractérisé en ce qu'il comporte, en outre, une capacité (28) branchée en parallèle sur la diode Zener (26).

4. Circuit électronique selon la revendication 1, caractérisé en ce que ledit amplificateur (19) comprend :

- un second transistor bipolaire (25), de polarité inverse à celle du premier transistor bipolaire (17), dont la base est reliée à l'émetteur du premier transistor bipolaire (17) et le collecteur au point formé par la liaison de la première source de courant (18) au premier pôle de la source d'alimentation;

- une deuxième résistance (30) dont une borne est reliée à l'émetteur dudit second transistor bipolaire (25);

- un dipôle passif (31) dont une borne est reliée à l'autre borne de ladite deuxième résistance (30); et

- une seconde source de courant (32) dont une borne est reliée au point formé par la liaison de l'autre borne de la première résistance (20) et l'autre borne du dipôle passif (31), l'autre borne au second pôle de la source d'alimentation;

- une première sortie (8a) dudit circuit étant constituée par le point de liaison entre ledit dipôle passif (31) et ladite seconde source de courant (32); et

- une seconde sortie (8b) dudit circuit étant constituée par le point de liaison entre ladite deuxième résistance (30) et ledit dipôle passif (31).

5. Circuit électronique selon la revendication 4, caractérisé en ce qu'il comporte, en outre, une capacité (33) branchée entre l'émetteur du second transistor bipolaire (25) et la première sortie (8a) dudit circuit amplificateur.

6. Circuit électronique selon la revendication 4, caractérisé en ce que ledit dipôle passif (31) comprend une diode.

7. Circuit électronique amplificateur selon la revendication 1, caractérisé en ce qu'il comporte, en outre, un amplificateur d'interface ayant une entrée et une sortie, l'entrée dudit amplificateur d'interface étant connectée à la sortie dudit circuit électronique amplificateur.

8. Circuit électronique selon les revendications 4 et 7, caractérisé en ce que ledit amplificateur d'interface comporte :

- un troisième transistor bipolaire (35), de polarité inverse à celle du premier transistor bipolaire (17), dont le collecteur est relié au premier pôle de la source d'alimentation;

- une troisième résistance (36) dont une borne est reliée à l'émetteur du troisième transistor bipolaire (35);

- une quatrième résistance (37) dont une borne est reliée à l'autre borne de la troisième résistance (36); et

- un quatrième transistor bipolaire (38), de même polarité que le premier transistor bipolaire (17), dont l'émetteur est relié à l'autre borne de la quatrième résistance (37) et le collecteur au second pôle de la source d'alimentation;

- une première entrée (8c) dudit amplificateur d'interface, reliée à la première sortie (8a) dudit circuit électronique amplificateur, étant constituée par la base du quatrième transistor bipolaire (38);

- une seconde entrée (8d) dudit amplificateur d'interface, reliée à la seconde sortie (8b) dudit circuit électronique amplificateur, étant constituée par la base du troisième transistor bipolaire (35); et

- la sortie (40) dudit amplificateur d'interface étant constituée par le point de liaison des troisième (36) et quatrième (37) résistances.

Fig.1

Fig.2

Fig.3

Fig.4a

Fig.4b

Fig.4c

Fig.4d

Fig.5

Fig.6

Fig.7